# EUROPEAN PATENT APPLICATION

(11) **EP 1 744 322 A1**
(43) Date of publication of application: **17.01.2007**
(21) Application number: 06253434.2
(22) Date of filing: 30.06.2006
(51) Int. Cl.: G11C 11/56

(54) **Devices containing multi-bit data**

(30) Priority: 08.07.2005 US 697604 P; 17.03.2006 US 384059 P
(71) Applicant: Rohm and Haas Electronic Materials, L.L.C., Marlborough, Massachusetts 01752 (US)
(72) Inventor: Cutler, Charlotte, Waltham Massachusetts 02453 (US); Greer, Edward C., Lower Gwyneld Pennsylvania 19002 (US); Szmanda, Charles R., Westborough Massachusetts 01581 (US)
(74) Representative: Kent, Venetia Katherine

(57) **Abstract**

Cross-point memory array devices containing an electric field programmable film with data stored in multi-bit format are provided. Also provided are data processing devices comprising cross-point memory array devices with data stored in multi-bit format. Further provided are methods of storing multi-bit data in cross-point memory array devices and methods of using such devices.

## Description

The present invention claims the benefit of U.S. Patent Application Serial No. 11/384,059, filed on March 17, 2006, and claims the benefit of U.S. Provisional Patent Application No. 60/697,604, filed on July 8, 2005.

The present invention relates to a method of storing multi-bit data in a memory device comprising a cross-point memory array, wherein the cross-point memory array comprises an electric field programmable film. The present invention also relates to devices comprising a cross-point memory array with an electric field programmable film containing multi-bit data and methods of using the same.

Bistable cross-point memory array devices are disclosed in, for example, U.S. Patent No. 6,646,912 to Hurst et al. Hurst et al. disclose a data storage device, comprising a cross-point memory array formed on a dielectric substrate material, the cross-point memory array comprising first and second sets of transverse electrodes separated by a storage layer including at least one semiconductor layer, the storage layer forming a non-volatile memory element at each crossing point of electrodes from the first and second sets, each memory element being switchable between low and high impedance states, representing respective binary data states, by application of a write signal in the form of a predetermined current density through th ememory element, each memory element including a diode junction and a fuse or an anti-fuse formed in said storage layer.

Notwithstanding, it would be advantageous to provide cross-point memory array devices and methods of using the same that facilitate and utilize multi-bit data storage and retrieval.

In one aspect of the present invention, there is provided a method for storing multi-bit data in a memory device comprising a cross-point memory array, comprising: (a) providing a bit line array; (b) providing a word line array; (c) providing at least one memory cell comprising an electric field programmable film (i) disposed within a spatial intersection between at least one bit line in the bit line array and at least one word line in the word line array and (ii) electrically coupled with the at least one bit line and the at least one word line; and, (d) writing data to the cross-point memory array by applying a program voltage across the electric field programmable film in at least one of the at least one memory cell to program the at least one of the at least one memory cell to one of at least three different data states.

In another aspect of the present invention, there is provided a method for storing multi-bit data in a memory device comprising a cross-point memory array, comprising: (a) providing a bit line array; (b) providing a word line array; (c) selecting an electric field programmable film composition from formulation A and formulation B; (d) obtaining an electric field programmable film with the electric field programmable film composition; (e) providing at least one memory cell comprising the electric field programmable film (i) disposed within a spatial intersection between at least one bit line in the bit line array and at least one word line in the word line array and (ii) electrically coupled with the at least one bit line and the at least one word line; and (f) writing data to the cross-point memory array by applying a program voltage across the electric field programmable film in at least one of the at least one memory cell to program the at least one of the at least one memory cell to one of at least three different data states; wherein formulation A comprises a binder, at least one electron donor and at least one electron acceptor; wherein at least one of (i) the at least one electron donor and (ii) the at least one electron acceptor is chemically bound to the binder; and wherein either (i) the at least one electron donor comprises at least two electron donors having different ionization potentials; or (ii) the at least one electron acceptor comprises at least two electron acceptors having different electron affinities; and, wherein formulation B comprises a binder, at least one electron donor and at least one electron acceptor; wherein formulation B either (i) contains less than 0.05 wt% of electron donor(s) or (ii) contains less than 0.05 wt% of electron acceptor(s); and wherein either (i) the at least one electron donor comprises at least two electron donors having different ionization potentials; or (ii) the at least one electron acceptor comprises at least two electron acceptors having different electron affinities.

In another aspect of the present invention, there is provided a cross-point memory array device, comprising: a bit line array; a word line array; and, a multiplicity of memory cells comprising an electric field programmable film (i) disposed within a spatial intersection between at least one bit line in the bit line array and at least one word line in the word line array and (ii) electrically coupled with the at least one bit line and the at least one word line; wherein the cross-point memory array device contains data stored in multi-bit format.

In another aspect of the present invention, there is provided a data processing device comprising a cross-point memory array device of the present invention, wherein the cross-point memory array device contains data stored in multi-bit format.

In another aspect of the present invention, there is provided a data processing device interfaced with a cross-point memory array device of the present invention, wherein the cross-point memory array device contains data stored in multi-bit format.

### DESCRIPTION OF THE DRAWINGS

**Figure 1** depicts a schematic view of an electric field programmable film of the present invention;

**Figure 2** depicts a schematic view of another cross-point array data storage device of the present invention;

**Figure 3** depicts a schematic cutaway plan view of a cross-point array data storage device of the present invention with a continuous electric field programmable film;

**Figure 4** depicts a schematic cutaway plan view of a cross-point array data storage device of the present invention with a pixelated electric field programmable film;

**Figure 5** depicts a schematic diagram of a cross-point array device of the present invention;

**Figure 6** depicts a schematic diagram of another cross-point array device of the present invention;

**Figure 7** depicts a cutaway, partially exploded view of a stacked, two layer, cross-point array data storage device of the present invention on a substrate;

**Figure 8** depicts a cutaway, partially exploded view of another stacked cross-point array data storage device of the present invention on a substrate;

**Figure 9(a)** depicts a cutaway, partially exploded view of another stacked cross-point array data storage device of the present invention having three device layers on a substrate;

**Figure 9(b)** depicts a cutaway, partially exploded view of another stacked cross-point array data storage device of the present invention having two device layers on a substrate;

**Figure 10** depicts a cutaway view of a cross-point array memory device of the present invention with a contiguous electric field programmable film and memory cells isolated by junction diodes;

**Figure 11** depicts a cutaway, exploded view of the memory device depicted in **Figure 10**;

**Figure 12** depicts a current-voltage curve for an embodiment of a memory cell of the present invention.

### DETAILED DESCRIPTION

A cross-point array is a device comprising a first set of substantially parallel electrodes (also referred to herein as "lines") running along a first direction, a second set of substantially parallel electrodes running along a second direction, wherein an electric field programmable film is disposed within some or all of the spatial intersections between the electrodes from the first set of electrodes and the electrodes from the second set of electrodes and further wherein the first direction is at an angle of 1 to 179 degrees to the second direction.

In some embodiments of the present invention, the electric field programmable film is provided as either a continuous layer or a pixelated layer. In some aspects of these embodiments, the electric field programmable film has a first surface and a second surface, wherein the first surface and the second surface are substantially parallel. In some aspects of these embodiments, the bit line array is in electrical contact with the first surface and the word line is in electrical contact with the second surface. In some aspects of these embodiments, the bit line array is disposed on and is in electrical contact with the first surface. In some aspects of these embodiments, the word line array is disposed on and is in electrical contact with the second surface.

The terms "electrical coupling" as used herein and in the appended claims encompasses ohmic contact, capacitive coupling and/or inductive coupling.

The term "chemically bonded" as used herein and in the appended claims encompasses covalently bonded, ionically bonded and hydrogen bonded.

The term "derivatives" as used herein and in the appended claims, in reference to an electron donor or an electron acceptor, encompasses chemical modifications and analogs of the referenced electron donor or electron acceptor such as, for example, isomers, chemical substitutions, and instances in which the electron donor or electron acceptor is chemically bonded to a binder or incorporated into the binder as a monomer unit.

In some embodiments of the present invention, the binder exhibits a dielectric constant of 2 to 1000. In some aspects of these embodiments, the methods of the present invention further comprise selecting a fundamentally non-conductive binder having a dielectric constant of 2 to 1,000.

In some embodiments of the present invention, the binder exhibits sufficient chemical and thermal resistance to withstand processes involving the deposition of metals, etch barrier layers, seed layers, metal precursors, photoresists and antireflective coatings.

In some embodiments of the present invention, the binder imparts a low level of electrical conductivity to the electric field programmable film and permits for a loading of a sufficiently high concentration of electron donors and electron acceptors to enable a sufficiently high conductivity through the electric field programmable film so that the difference between each of the at least three data states can be readily discerned. In some aspects of these embodiments, the electrical conductivity of the binder is less than or equal to about 10⁻¹⁰ ohm⁻¹cm-¹. In some aspects of these embodiments, the selection of the binder, the electron donor(s), the electron acceptor(s) and the relative loadings thereof, provides for the ratio of the electrical conductivity between adjacent data states to be ≥ 5, alternatively ≥ 100, alternatively ≥ 500.

In some embodiments of the present invention, the binder is selected from, for example, oligomers; polymers; ionomers; dendrimers; copolymers (e.g., block copolymers, random copolymers, graft copolymers, star copolymers); inorganics and combinations thereof. In some aspects of these embodiments, the binder is selected from organic polymers, inorganic polymers and combinations thereof. In some aspects of these embodiments, the binder is an organic polymer. In some aspects of these embodiments, the binder is an inorganic polymer.

In some embodiments of the present invention, the binder is chemically bonded, alternatively covalently bonded, to at least one of the electron donor(s) and/or at least one of the electron acceptor(s). In some aspects of these embodiments, the at least one of the electron donor(s) and/or the at least one of the electron acceptor(s) is chemically bonded to at least one segment of the binder. In some aspects of these embodiments, the at least one of the electron donor(s) and/or the at least one of the electron acceptor(s) is covalently bonded to at least one segment of the binder.

In some embodiments of the present invention, the binder is selected from polymers including, for example, polyacetals, polyacrylics, polycarbonates, polystyrenes, polyesters, polyamides, polyamideimides, polyarylates, polyarylsulfones, polyethersulfones, polyphenylene sulfides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, polycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, polysiloxanes, and combinations thereof.

In some embodiments of the present invention, the binder is a copolymer selected from, for example, copolyestercarbonates, acrylonitrile butadiene styrene, styrene acrylonitrile, polyimide-polysiloxane, polyester-polyetherimide, polymethylmethacrylate-polysiloxane, polyurethane-polysiloxane, and combinations thereof.

In some embodiments of the present invention, the binder is selected from mixtures of polymers. In some aspects of these embodiments the polymers are crosslinkable. In some aspects of these embodiments, the binder comprises at least two polymers, wherein one of the at least two polymers is chemically bound, alternatively covalently bound, to an electron donor and/or an electron acceptor and wherein one of the at least two polymers is not chemically or covalently bound, to either the electron donor or electron acceptor. In some aspects of these embodiments, the binder comprises at least two polymers, wherein one of the at least two polymers is chemically bound, alternatively covalently bound, to an electron donor and another one of the at least two polymers is chemically bound, alternatively covalently bound, to an electron acceptor. In some aspects of these embodiments, the mixtures of polymers employed facilitate the fine tuning of the properties of the electric field programmable film. For example, in some aspects of these embodiments, the polymer mixture is selected to balance the charge carrier density in a given electric field programmable film composition.

In some embodiments of the present invention, the binder is a mixture of polymers. In some aspects of these embodiments, the binder is selected from a mixture of polymers selected from, for example, acrylonitrile-butadiene-styrene/nylon, polycarbonate/acrylonitrile-butadiene-styrene, acrylonitrile butadiene styrene/polyvinyl chloride, polyphenylene ether/polystyrene, polyphenylene ether/nylon, polysulfone/acrylonitrile-butadiene-styrene, polycarbonate/thermoplastic urethane, polycarbonate/polyethylene terephthalate, polycarbonate/polybutylene terephthalate, thermoplastic elastomer alloys, nylon/elastomers, polyester/elastomers, polyethylene terephthalate/polybutylene terephthalate, acetal/elastomer, styrene-maleicanhydride/acrylonitrile-butadiene-styrene, polyether etherketone/polyethersulfone, polyethylene/nylon, polyethylene/polyacetal, and combinations thereof.

In some embodiments of the present invention, the binder is an inorganic or partially inorganic material. In some aspects of these embodiments, the binder comprises at least one of a silicone and a silsesquioxane.

In some embodiments of the present invention, the binder is functionalized to facilitate at least one of crosslinking, chemical bonding with an electron donor, chemical bonding with an electron acceptor, covalent bonding with an electron donor and covalent bonding with an electron acceptor. In some embodiments of the present invention, the binder is a polymer or combination of polymers having a number average molecular weight of 500 to 1,000,000 grams/mole; alternatively 3,000 to 500,000 grams/mole; alternatively 5,000 to 100,000 grams/mole; alternatively 10,000 to 30,000 grams/mole.

In some embodiments of the present invention, the binder is crosslinked. In some aspects of these embodiments, the crosslinking occurs through reactions at functional groups chemically bonded, alternatively covalently bonded, to the backbone of the binder. In some aspects of these embodiments, the crosslinking occurs through non-covalent bonding. In some aspects of these embodiments, the binder is crosslinked using a crosslinking agent selected from a silane, an ethylenically unsaturated resin, an aminoplast resin, a phenolic, a phenolformaldehyde resin, an epoxy, and combinations thereof.

In some embodiments of the present invention, the electric field programmable film composition comprises a crosslinking agent. In some aspects of these embodiments, the electric field programmable film composition contains 0.01 to 20 wt%, alternatively 0.1 to 15 wt%, alternatively 0.5 to 10 wt%, alternatively 1 to 7 wt% crosslinking agents (based on total solids).

In some embodiments of the present invention, the electric field programmable film composition comprises an, optional, acid and/or acid generator. In some aspects of these embodiments, the addition of an acid and/or an acid generator catalyzes or promotes crosslinking of the binder during curing of the electric field programmable film. In some aspects of these embodiments, the acid is selected from aromatic sulfonic acids (e.g., toluene sulfonic acid, benzene sulfonic acid, p-dodecylbenzene sulfonic acid); fluorinated alkyl or aromatic sulfonic acids (e.g., o-trifluoromethylbenzene sulfonic acid, triflic acid, perfluoro butane sulfonic acid, perfluoro octane sulfonic acid); and combinations thereof. In some aspects of these embodiments, the acid generator is a thermal acid generator selected from 2,4,4,6-tetrabromocyclohexadienone; benzoin tosylate; 2-nitrobenzyl tosylate; 4-nitrobenzyl tosylate; and combinations thereof. In some aspects of these embodiments, the electric field programmable film composition contains 0.01 to 10 wt%, alternatively 0.1 to 8 wt%, alternatively 0.5 to 5 wt%, alternatively 1 to 3 wt% acid and/or acid generator (based on total solids).

In some embodiments of the present invention, the electron donor(s) are selected from anthracene; tetrathiafulvalene; 4,4',5-trimethyltetrathiafulvalene; bis(ethylenedithio)tetrathiafulvalene; p-phenylenediamine; carbazole; substituted carbazole (e.g., N-vinyl carbazole); tetrathiotetracene; hexamethylbenzene; tetramethyltetraselenofulvalene; hexamethylenetetraselenofulvalene; 8-hydroxyquinoline; phenyl azorecorcinol and similar azo dyes; N,N'-bis(3-methylphenyl)-N,N'-diphenylbenzidine; phenothiazine; substituted phenothiazines (e.g., N-vinyl phenothiazine); pyrene; acenaphthylene; acridine; triphenylene; phthalocyanine; 2-amino-1H-imidazole-4,5-dicarbonitrile (AIDCN); substituted AIDCN (e.g., N-vinyl AIDCN); derivatives thereof; and combinations thereof.

In some embodiments of the present invention, the electron donor(s) is an electron donor derivative chemically bound to a binder (hereinafter and in the claims represented by "electron donor derivative-binder"). In some aspects of these embodiments, the electron donor derivative-binder is selected from 9-anthracenemethyl methacrylate/2-hydroxyethyl methacrylate/3-(trimethoxysilyl)propyl methacrylate terpolymer; a quinolin-8-yl methacrylate/2-hydroxyethyl methacrylate copolymer; a 9-anthracenemethyl methacrylate/2-hydroxyethyl methacrylate copolymer; a quinolin-8-yl methacrylate/2-hydroxyethyl methacrylate/3-(trimethoxysilyl)propyl methacrylate terpolymer; a 9-anthracenemethyl methacrylate; a quinolin-8-yl-methacrylate; and combinations thereof.

In some embodiments of the present invention, the electron acceptor(s) are selected from pentafluoroaniline; phthalocyanine; perfluorophthalocyanine; tetraphenylporphine; 2-(9-dicyanomethylene-spiro[5.5]undec-3-ylidene)-malononitrile; 4-phenylazo-benzene-1,3-diol; 4-(pyridin-2-ylazo)-benzene-1,3-diol; benzo[1,2,5]thiadiazole-4,7-dicarbonitrile; tetracyanoquinodimethane; quinoline; chlorpromazine; fullerene C₆₀ (e.g., Buckminsterfullerene C₆₀); fullerene C₇₀ (e.g., Buckminsterfullerene C₇₀); perylene-3,4:9,10-tetracarboxydiimide; trinitrobenzene; 2-(3-Nitro-benzilidene)-malononitrile; hexacyanobutadiene; anhydrides; derivatives and combinations thereof. In some aspects of these embodiments, the electron acceptor(s) are selected from fullerene C₆₀; fullerene C₇₀; derivatives thereof; and combinations thereof.

In some embodiments of the present invention, the electron acceptor(s) are selected from, for example, anhydrides, dianhydrides, imides and diimides (e.g., phthalic, especially those with 4 halogens on the ring; pyromellitic dianhydride; naphthalene-tetracaboxylic-dianhydride (NTCDA); perylene-tetracarboxylic-dianhydride (PTCDA)); benzoquinones (e.g., tetra-halogenated and tetracyano derivatives); naphthoquinones; anthraquinones; cyano-compounds (e.g., tetracyanoethylene (TCNE), TCNQ, AIDCN); nitro compounds having at least three nitro groups (e.g., benzenes, naphthalenes, trinitrofluorenone, nitrated dibenzothiophenedioxide, nitrated phenylsulfones); poly-sulfones (e.g., 1,4-bis(phenylsulfonyl)benzene); viologens; viologen salts; 1,3,5-triazines (e.g., halogen and cyano derivatives thereof); alpha diketones (e.g., indanetrione); sulfur; derivatives; and combinations thereof.

In some embodiments of the present invention, the electric field programmable film composition contains < 1 wt%; alternatively < 0.5 wt%; alternatively ≤ 0.4 wt%; alternatively ≤ 0.3 wt%; alternatively ≤ 0.25 wt%; alternatively ≤ 0.2 wt%; alternatively ≤ 0.1 wt%; alternatively ≤ 0.09 wt%; alternatively ≤ 0.075 wt%; alternatively ≤ 0.05 wt% electron donor(s) (based on total solids).

In some embodiments of the present invention, the electric field programmable film composition contains < 1 wt%; alternatively < 0.5 wt%; alternatively ≤ 0.4 wt%; alternatively ≤ 0.3 wt%; alternatively ≤ 0.25 wt%; alternatively ≤ 0.2 wt%; alternatively ≤ 0.1 wt%; alternatively ≤ 0.09 wt%; alternatively ≤ 0.075 wt%; alternatively ≤ 0.05 wt% electron acceptor(s) (based on total solids).

In some embodiments of the present invention, either the electron donor(s) or the electron acceptor(s) are provided in relative excess. In some aspects of these embodiments, the electric field programmable film composition will contain a higher concentration of electron donor(s) relative to the concentration of electron acceptor(s). In some aspects of these embodiments, the electric field programmable film composition will contain a higher concentration of electron acceptor(s) relative to the concentration of electron donor(s). In some aspects of these embodiments, the concentration of the electron donor(s) in the electric field programmable film composition is 0.002 to 0.1 µmol/hg; alternatively 0.005 to 0.1 µmol/hg; alternatively 0.005 to 0.05 µmol/hg; alternatively 0.01 to 0.05 µmol/hg; and the concentration of the electron acceptor(s) in the electric field programmable film composition is 10 to 300 µmol/hg; alternatively 10 to 200 µmol/hg; alternatively 10 to 150 µmol/hg; alternatively 25 to 125 µmol/hg; alternatively 25 to 100 µmol/hg; alternatively 50 to 100 µmol/hg. In some aspects of these embodiments, the concentration of the electron acceptor(s) in the electric field programmable film composition is 0.002 to 0.1 µmol/hg; alternatively 0.005 to 0.1 µmol/hg; alternatively 0.005 to 0.05 µmol/hg; alternatively 0.01 to 0.05 µmol/hg; and the concentration of the electron donor(s) in the electric field programmable film composition is 10 to 300 µmol/hg; alternatively 10 to 200 µmol/hg; alternatively 10 to 150 µmol/hg; alternatively 25 to 125 µmol/hg; alternatively 25 to 100 µmol/hg; alternatively 50 to 100 µmol/hg. The selection of whether to provide electron donor(s) or electron acceptor(s) in relative excess depends on the specific electron acceptor(s) and electron donor(s) used as well as on the desired type of charge carrier (electrons or holes). Without wishing to be bound by theory, it is believed that, for example, if an anthracene is an electron donor and a fullerene is an electron acceptor and the anthracene is provided in excess relative to the fullerene, the predominant charge carriers will be holes that traverse individually from a positively charged anthracene group to a neutral anthracene group. Conversely, it is believed that if an electron acceptor is tetracyanoquinodimethane (TCNQ) and an electron donor is phenothiazine and TCNQ is provided in relative excess, the predominant charge carriers will be electrons, transferred from the phenothiazine to a small number of TCNQ groups, that traverse individually from a negatively charged TCNQ group to a neutral TCNQ group.

In some embodiments of the present invention, the electron acceptor(s) are selected from molecules or derivatives that exhibit an electron affinity greater than 0.8 eV, alternatively greater than 1.2 eV. In some aspects of these embodiments, the selection of the electron acceptor is influenced by its ionization potential. In some aspects of these embodiments, at least two electron acceptors are used.

In some embodiments of the present invention, the electron donor(s) are selected from molecules or derivatives that exhibit an ionization potential less than 8.5 eV; alternatively less than 8.0 eV. In some aspects of these embodiments, the selection of the electron donor(s) is influenced by its ionization potential. In some aspects of these embodiments, at least two electron donors are used.

Note that some molecules or derivatives have an electron affinity and an ionization potential such that they may function as either an electron donor or an electron acceptor depending on the selection of the other components of the electric field programmable film composition (e.g., phthalocyanine). Without wishing to be bound by theory, in comparing molecules or derivatives, the molecule or derivative with the lowest ionization potential is usually considered to be an electron donor, while the molecule or derivative with the highest ionization potential is usually considered to be an electron acceptor.

In some embodiments of the present invention, the electric field programmable film composition further comprises an optional donor-acceptor complex, which operates to adjust the properties of the film, for example, the voltage required to program the film to a given data state and/or the conductivity associated with a given data state. In some aspects of these embodiments, the electric field programmable film composition contains 0.05 to 5 wt%, alternatively 0.5 to 4 wt%, alternatively 1 to 3.5 wt%, alternatively 1.5 to 3 wt% of the optional donor-acceptor complex. In some aspects of these embodiments, the electric field programmable film composition comprises an optional donor-acceptor complex selected from, for example, tetrathiafulvalene--tetracyanoquinodimethane; hexamethylenetetrathiafulvalene--tetracyanoquinodimethane; tetraselenafulvalene--tetracyanoquinodimethane; hexamethylenetetraselenafulvalene--tetracyanoquinodimethane; methylcarbazole--tetracyanoquinodimethane; tetramethyltetraselenofulvalene--tetracyanoquinodimethane; ferrocene--tetracyanoquinodimethane; (tetrathiotetracene, tetramethyl-p-phenylenediamine, or hexamethylbenzene)--tetracyanoquinodimethane; (tetrathiafulvalene, hexamethylenetetrathiafulvalene, tetraselenafulvalene, hexamethylenetetraselenafulvalene, or tetramethyltetraselenofulvalene)--N-alkylcarbazole(C₁-C₁₀, linear or branched); (tetrathiotetracene, tetramethyl-p-phenylenediamine, or hexamethylbenzene)--Buckminsterfullerene C₆₀; (tetrathiotetracene, tetramethyl-p-phenylenediamine, or hexamethylbenzene)--Buckminsterfullerene C₇₀; (tetrathiotetracene, tetramethyl-p-phenylenediamine, or hexamethylbenzene)--tetracyanobenzene; (tetrathiotetracene, tetramethyl-p-phenylenediamine, or hexamethylbenzene)--tetracyanoethylene; (tetrathiotetracene, tetramethyl-p-phenylenediamine, or hexamethylbenzene)--p-chloranil; and combinations thereof.

In some embodiments of the present invention, combinations of electron donor(s) and electron acceptor(s) are selected to provide multi-threshold switching. By way of illustration, two electron donors having different ionization potentials (e.g., phthalocyanine and 9-methyl anthracene) can be combined with an electron acceptor (e.g., Buckminsterfullerene C60). The ionization potential of phthalocyanine is 6.54 eV, as estimated by PM3 semiempirical molecular orbital theory. The ionization potential of 9-methyl anthracene is 7.56 eV, as estimated by PM3 semiempirical molecular orbital theory. The electron affinity of Buckminsterfullerene C60 is 2.47 eV, as measured experimentally (Palpant et al., Phys. Rev. B-Condens Matter, 1999, 60, 4509-4512). Without wishing to be bound by theory, when electron donors having different ionization potentials are combined with an electron acceptor, the electron donors will transfer electrons to the electron acceptor at different electric field strengths providing multi-threshold switching. In some aspects of these embodiments, interactions between the binder and the electron donor(s) and electron acceptor(s) can influence the field strengths at which electrons are donated/accepted between the various electron donor(s) and electron acceptor(s) in a given electric field programmable film.

**Table 1** provides a list of compound with their ionization potentials and electron affinities estimated using the semiempirical PM3 model within the Gaussian 98 Molecular orbital program (Frisch, et al.), unless otherwise specified. The notation, MPW1PW91/LANL2DZ, within **Table 1** signifies that the parameters were calculated with Moller-Plesset perturbation theory, using the LANL2DZ basis set. The notation B3LYP/LANL2DZ within **Table 1** signifies that the parameters were estimated using the density functional B3LYP model in the LANL2DZ basis set.

**Table 1**

| Compound | Electron Affinity (eV) | Ionization Potential (eV) |
|---|---|---|
| tetrathiafulvalene MPW1PW91/LANL2DZ | -1.292 | 6.529 |
| phthalocyanine | 3.354 | 6.538 |
| N,N'-bis (3-methylphenyl)-N,N'-diphenylbenzidine | 0.657 | 6.668 |
| phenothiazine MPW1PW91/LANL2DZ | -0.964 | 6.697 |
| 9,10-dimethyl anthracene MPW1PW91/LANL2DZ | 0.182 | 6.848 |
| 9-methyl anthracene MPW1PW91/LANL2DZ | 0.187 | 7.017 |
| phenothiazine | 1.090 | 7.134 |
| 2-(4-Diphenylamino-benzylidene)-malononitrile | 2.432 | 7.173 |
| N-methyl carbazole MPW1PW91/LANL2DZ | -0.721 | 7.232 |
| ferrocene MPW1PW91/LANL2DZ | -1.152 | 7.345 |
| N-methyl carbazole | 0.970 | 7.372 |
| phenyl azorecorcinol MPW1PW91/LANL2DZ | 0.430 | 7.411 |
| dimethyl anthracene | 1.533 | 7.421 |
| tetrathiafulvalene | 1.623 | 7.521 |
| methyl anthracene | 1.530 | 7.555 |
| phenylazo recorcinol | 1.656 | 7.610 |
| Pyrene | 1.617 | 7.656 |
| 8-hydroxyquinoline B3LYP/LAN2DZ | 0.144 | 7.818 |
| perylene bis(N dicarboximide) MPW1 PW91/LANL2DZ | 2.673 | 7.966 |
| acenaphthalene MPW1PW91/LANL2DZ | 0.387 | 7.968 |
| acridine | 1.796 | 8.041 |
| acenaphthylene | 1.691 | 8.096 |
| triphenylene | 1.217 | 8.114 |
| fluorenone | 2.441 | 8.124 |
| 8-hydroxyquinoline | 1.246 | 8.132 |
| Phenazine MPW1PW91/LANL2DZ | 1.075 | 8.143 |
| 8-hydroxyquinoline Isoamyl ester | 1.362 | 8.179 |
| perylene bis(2,6-dimethylphenyl-N dicarboximide) | 3.267 | 8.269 |
| fluorenone MPW1PW91/LANL2DZ | 0.846 | 8.303 |
| Phenazine | 2.072 | 8.370 |
| 6-Hydroxy-4-methyl-chromen-2-one | 1.754 | 8.417 |
| 2-amino-4,5-imidazoledicarbonitrile | 1.882 | 8.496 |
| pentafluoroaniline | 1.686 | 8.497 |
| diazo benzene | 1.781 | 8.508 |
| 2-amino-4,5-imidazoledicarbonitrile - B3LYP/LAN2DZ | 0.448 | 8.574 |
| Triptycene | 0.435 | 8.670 |
| naphthalene-2,6-dicarboxylic acid dimethyl ester | 1.893 | 8.691 |
| tetracyanoquinodimethane | 3.868 | 8.752 |
| perylene bis(N dicarboximide) | 3.244 | 8.824 |
| tetracyanoquinodimethane MPW1PW91/LANL2DZ | 3.407 | 9.251 |
| 2-amino-4,5-imidazoledicarbonitrile MPW1PW91/LANL2DZ | 0.394 | 9.352 |
| anthraquinone | 1.907 | 9.500 |
| 2-(3-Nitro-benzylidene)-malononitrile | 2.758 | 9.616 |
| trimethylcyanurate | 1.242 | 10.501 |
| tetrafluorobenzoquinone | 3.195 | 10.822 |
| tetrafluorobenzoquinone MPW1PW91/LANL2DZ | 2.964 | 11.151 |
| trinitrobenzene | 3.373 | 11.441 |

In some embodiments of the present invention, an electron donor and an electron acceptor are provided as a donor-acceptor complex or form a donor-acceptor complex *in-situ* when added to a binder. In some aspects of these embodiments, the donor-acceptor complexes disproportionate *in-situ* when added to a binder.

In some embodiments of the present invention, the electric field programmable film composition optionally contains processing agents. In some aspects of these embodiments, the processing agents are selected from surfactants, mold release agents, accelerators, anti-oxidants, thermal stabilizers, anti-ozonants, fillers and fibers, and combinations thereof.

The electric field programmable film can be manufactured by a variety of conventional methods. In some embodiments of the present invention, the electric field programmable film is prepared by depositing an electric field programmable film composition on a substrate. The deposited film composition may then be dried and/or cured to form the electric field programmable film. Alternatively, the electric field programmable film composition can be cast in the presence of an optional solvent. The electric field programmable film can then be cast from solution and the solvent evaporated. Some methods for casting the film include spin coating, spray coating, electrostatic coating, dip coating, blade coating and slot coating. Alternatively, the electric field programmable film can be manufactured by processes including injection molding, vacuum forming, blow molding and compression molding.

Substrates suitable for use with the present invention include, for example, semiconducting substrates (e.g., doped silicon wafers) and conducting substrates (e.g., aluminum, titanium, vanadium, chromium, manganese, iron, cobalt, nickel, copper, zinc, zirconium, niobium, molybdenum, ruthenium, rhodium, palladium, silver, cadmium, hafnium, tantalum, tungsten, rhenium, osmium, iridium, platinum, gold mercury, tin, germanium, lead, and alloys thereof). In some embodiments of the present invention, the substrate can be patterned.

In some embodiments of the present invention, the electric field programmable film has a thickness of 5 to 5000 nanometers, depending on the requirements of the device it is to be incorporated into. In general, the programming voltages are linear in the film thickness. In some aspects of these embodiments, when incorporated into a device requiring programming voltage magnitudes below about 10 V, the electric field programmable film exhibits a film thickness (after optional curing) of about 10 to 100 nm. In some aspects of these embodiments, when incorporated into a device requiring programming voltage magnitudes below about 5 V, the electric field programmable a film exhibits a thickness (after optional curing) of 5 to 50 nm.

In some embodiments of the present invention, the electrodes are electrically coupled to the electric field programmable film. In some aspects of these embodiments, the electric field programmable film is in ohmic contact with at least one electrode. In some aspects of these embodiments, the electric field programmable film is in capacitive contact with at least one electrode. In some aspects of these embodiments, the cross point array advantageously includes an electrical coupling element. In some aspects of these embodiments, the electrical coupling element provides ohmic contact, contact via a conducting plug, capacitive contact, contact via an intervening tunnel junction, or contact via an intervening isolation device such as a diode or a transistor or contact via other electrical devices. In some aspects of these embodiments, the electrical coupling elements comprise a bit line and a word line.

A word line is a conductor or semiconductor that selects the desired memory cell in a cross-point array memory device. It is also sometimes called the select line. When the word line is asserted, the memory cell can be read, written or erased. When the device is symmetrical, the designation of "word line" or "bit line" can be arbitrary. A word line array is a plurality of word lines arranged in non-intersecting fashion, alternatively substantially parallel fashion.

A bit line is the conductor or semiconductor that reads, writes or erases the desired memory cell in a memory device. When the word line is asserted, the memory cell is selected and can be either read, written or erased. When the device is symmetrical, the designation of "word line" or "bit line" can be arbitrary. A bit line array is a plurality of bit lines arranged in nonintersecting fashion, alternatively substantially parallel fashion.

In some embodiments of the present invention, the electric field programmable film obtained from the electric field programmable film composition is used in electronic memory and switching devices or data storage devices. In some aspects of these embodiments, said devices contain either a single film or multiple films. Devices having multiple films that are substantially parallel and nonintersecting are generally termed stacked devices.

In some embodiments of the present invention, data processing devices are provided comprising or interfaced with a cross-point memory array device of the present invention. In some aspects of these embodiments, the data processing devices of the present invention are selected from any conventional data processing device that substitutes a cross-point memory array device of the present invention for a conventional memory device. In some aspects of these embodiments, the data processing devices are selected from, for example, personal computers, cell phones, personal digital assistants, set top boxes, still cameras, video cameras, audio players, video players, USB "thumb" drives, memory cards, "smart" cards and combinations thereof.

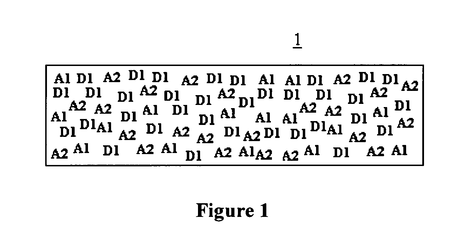

**Figure 1** depicts a continuous electric field programmable film, 1, of the present invention containing electron donors (**D1**) and electron acceptors (**A1** and **A2**).

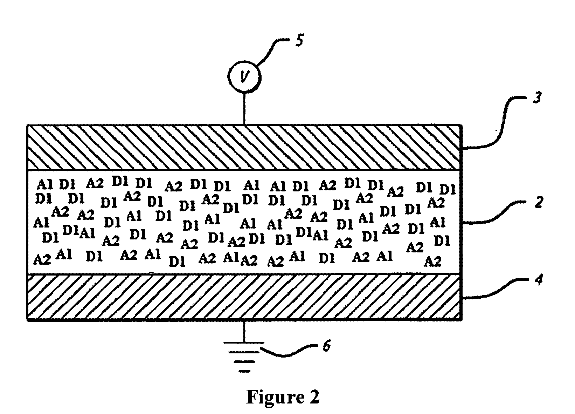

**Figure 2** depicts an example of a cross point array having a single, continuous electric field programmable film, **2,** electrically coupled to a first electrode, **3,** a second electrode, **4,** a variable program/read voltage source connected to the first electrode, **5** and a reference or ground connected to the second electrode, **6.**

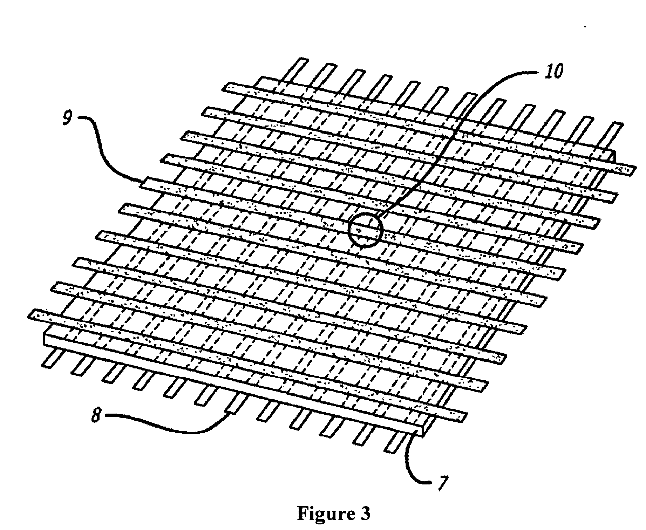

**Figure 3** depicts a schematic, cutaway, plan view of a cross-point array data storage device of the present invention with a continuous electric field programmable film, **7,** an array of word lines, an example of which is word line **8,** an array of bit lines, an example of which is bit line **9** and a multiplicity of memory cells, an example of which is memory cell **10,** formed by a portion of the interposing electric field programmable film **7** at the intersection of word line **8** and bit line **9.**

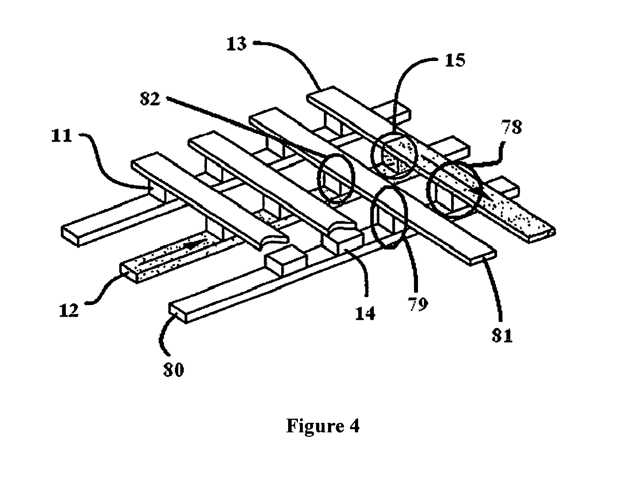

**Figure 4** depicts a schematic, cutaway, plan view of a cross-point array data storage device of the present invention with a pixelated electric field programmable film, examples of pixelated pieces of the electric field programmable film include **11** and **14.** These devices contain a plurality of memory cells, an example of which is memory cell **15.** Each such memory cell comprises a pixelated piece of electric field programmable film electrically coupled to a word line, for example word line **12,** and a bit line, for example bit line **13.**

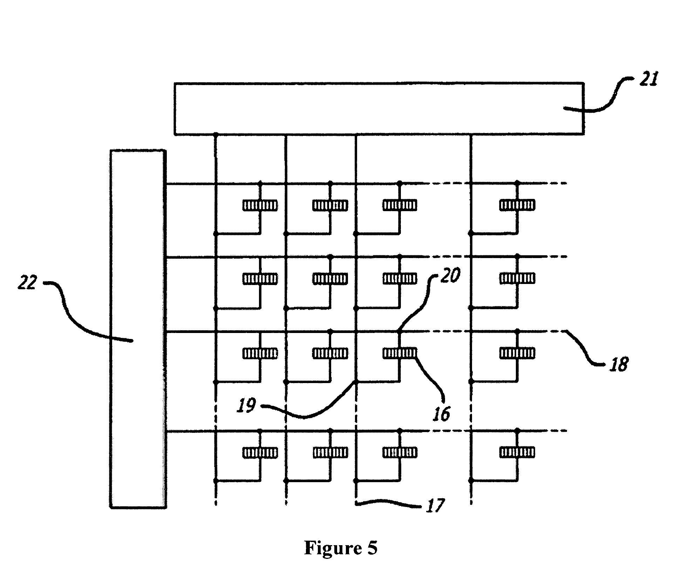

**Figure 5** depicts a schematic diagram of a cross-point array device of the present invention comprising memory cells, an example of which is memory cell **16,** electrically coupled to a bit line **17** and a word line **18** via connections **19** and **20,** respectively. Also depicted in **Figure 5,** in block diagram form, are sensing electronics **21** and polling electronics **22.**

In some embodiments of the present invention, there are provided cross-point array devices in which individual memory cells are electrically isolated from one another. In cross-point array devices such as those depicted in **Figures 2-5,** wherein individual memory cells are not electrically isolated from one another there is the potential for the occurrence of undesirable sneak currents. For example, in Figure 4, if a read voltage is applied to word line 12, because memory cell 15 is in a conductive state, bit line 13 will be charged. If, for example, memory cells 78 and 79 are also in the conductive state, a current would be able to sneak from bit line 15 down through memory cell 78 into wordline 80 up through memory cell 79 and thence into bitline 81. This would give the appearance that memory cell 82 is in the conductive state, when in fact it may not be. In some aspects of these embodiments, this isolation of memory cells is effected by introducing an asymmetry into the device.

In some embodiments of the present invention, the potential for sneak currents resulting in a false read are alleviated by forcing the nonselected bitlines and/or the nonselected wordlines to a predetermined voltage. In some aspects of these embodiments, the nonselected bitlines are forced to a predetermined voltage. In some aspects of these embodiments, the nonselected wordlines are forced to a predetermined voltage. In some aspects of these embodiments, both the nonselected bitlines and the nonselected wordlines are forced to a predetermined voltage.

In some embodiments of the present invention, asymmetry is provided by forming a inorganic oxide on one of the electrodes prior to the deposition of the electric field programmable film. In some aspects of these embodiments, the inorganic oxide layer is formed by allowing the metal of the electrode to form a native oxide in air or, more actively, by oxidizing the metal electrode in ozone. In this way, the two electrode surfaces are electrically coupled to the electric field programmable film in different ways; one is electrically coupled via capacitive coupling while the other is in direct contact. In some embodiments, the oxide coating on the electrode is sufficiently thin to enable charge injection into the electric field programmable film via tunneling, hot carrier injection or electron hopping. In some aspects of these embodiments, the oxide coating is an aluminum oxide coating with a thicknesses of 0.5 to 3.0 nm.

In some embodiments of the present invention, asymmetry is provided by selecting metals with differing work functions for the electrodes. The work function is defined as that energy required to remove an electron from the surface of the metal to infinity. Different crystal faces of metals and other elements exhibit different work functions. In some aspects of these embodiments, the electrodes used are polycrystalline. Accordingly, the work function comprises an average of the crystalline forms in contact with the electric field programmable film. By way of example, consider an electric field programmable film in contact with an aluminum electrode on one side (Φ~4.2 electron-volts (eV)) and a nickel electrode on the other (Φ~5.2 eV). If the forward bias is defined as proceeding from the aluminum electrode to the nickel electrode, with the aluminum electrode being the anode, the magnitude of a forward bias voltage will be higher than the magnitude of the reverse bias voltage. Among the transition elements, Al, Cr, Fe, Re, Ru, Ta, Ti), V, W and Zr all exhibit work functions less than 5 eV, Rh exhibits a work function of approximately 5 eV and Au, Cu, Ir, Ni, Pd, and Pt exhibit work functions greater than 5 eV.

In some embodiments of the present invention, asymmetry is introduced into the device using contact diodes. Examples of such diodes are described in L. S. Roman and O. Inganas, Synthetic Metals, 125, (2002), 419. In some aspects of these embodiments, the diodes comprise a low work function conducting polymer such as poly(3-(2'-methoxy-5'-octylphenyl)thiophene) (POMeOPT) (Φ~3 eV) in contact on one side with an Al electrode (Φ~4.2 eV) and on the other side with poly(3,4-ethylenedioxythiophene) doped with poly(4-styrenesulfonate) (PEDOT-PSS) (Φ~5.2 eV), which, in turn, is in contact with an aluminum electrode. In the device POMeOPT is interposed between the electric field programmable film and the metal electrode. Aluminum or some other metal having a similar work function electrode such as copper (Φ~4.5 eV) is applied to the opposite side of the electric field programmable film. Other organic conductors and semiconductors suitable for use in the devices of the present invention included doped polyaniline, doped polypyrrole, polythiophene, polyphenylene vinylene and indium-tin-oxide (ITO).

In some embodiments of the present invention, asymmetry is introduced into the device using semiconductor diodes.

In some embodiments of the present invention, asymmetry is introduced into the device using rectifying devices.

In some embodiments of the present invention, asymmetry is introduced into the device using a field effect isolation transistor. In some aspects of these embodiments, the electric field programmable film is electrically coupled to the source or the drain of the transistor either via a metal "plug" electrode or directly, such that the device can only be probed or programmed when the gate is in an "open" condition.

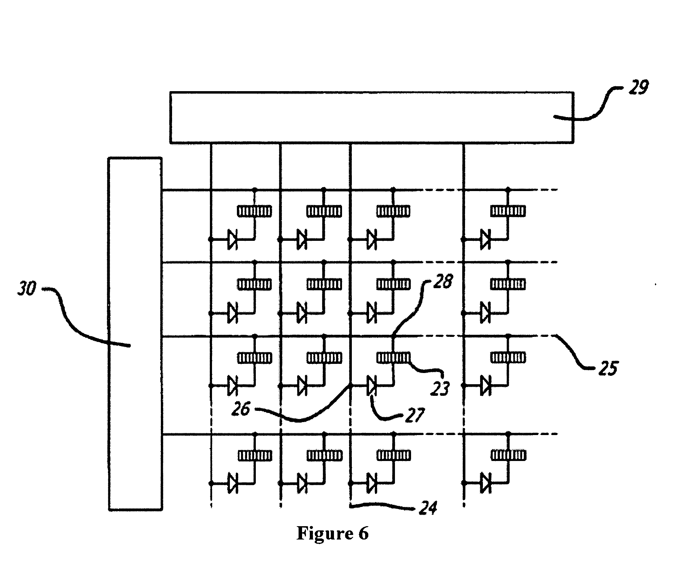

**Figure 6** depicts a schematic diagram of another cross-point array device of the present invention comprising a plurality of memory cells, an example of which is shown by **23,** electrically coupled to a bit line **24** and a word line **25.** The memory cells are electrically coupled to their respective bit lines, for example at **26,** via isolation diodes, for example **27,** and are electrically coupled to their respective word lines, for example at **28.** Also shown in block diagram form are polling electronics **29** and sensing electronics **30** used to address the individual bits and amplify the signals obtained from them.

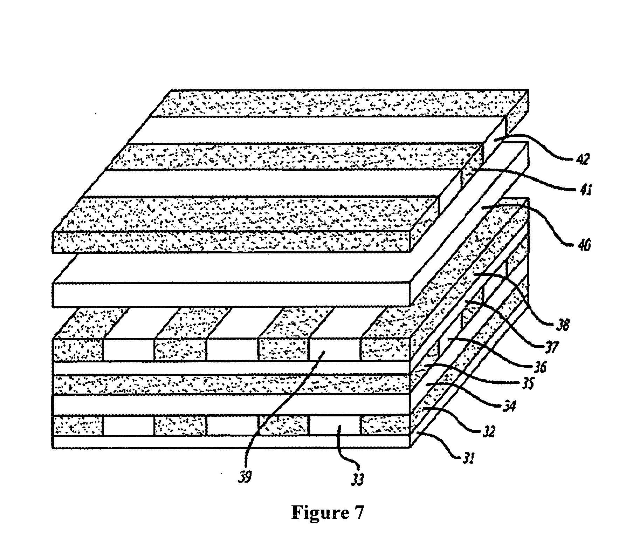

**Figure 7** depicts a cutaway, partially exploded view of a stacked, two layer, cross-point array data storage device on a substrate **31,** comprising a first device layer, having a line array with a first plurality of electrodes, exemplified by **32,** with each electrode being isolated from its nearest neighbors by an insulating material, exemplified by **33,** a first, continuous electric field programmable film **34** electrically coupled to the first plurality of electrodes and to a second plurality of electrodes, exemplified by **35,** in a line array with each electrode being isolated from its nearest neighbors by an insulating material, exemplified by **36,** a second device layer, separated from the first device layer by an insulating layer, **37,** having a line array with a third plurality of electrodes, exemplified by **38,** with each electrode being isolated from its nearest neighbors by an insulating material, exemplified by **39,** a second, continuous electric field programmable film, **40,** electrically coupled to the third plurality of electrodes and a fourth plurality of electrodes, exemplified by **41,** in a line array with each electrode being isolated from its nearest neighbor by an insulating material, exemplified by **42.**

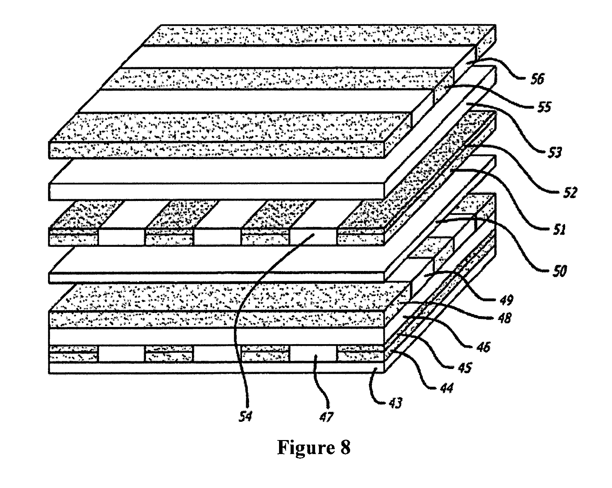

In some embodiments of the present invention, individual memory cells along, for example, a word line, are isolated to alleviate the occurance of sneak currents using contact diode structures. In **Figure 8,** for example, there is depicted a cutaway, partially exploded view of a two layer, stacked, cross-point array data storage device of the present invention containing contact diode structures. **Figure 8** further depicts a stacked data storage device having a substrate, **43,** a first device layer and a second device layer separated by an insulating layer **50.** The first device layer comprises a first line array containing a plurality of contact diodes, wherein neighboring contact diodes are separated from one another by lines of insulating material, exemplified by **47.** Each contact diode in the first line array contains a first material, exemplified by **44,** in electrical contact with a second material, exemplified by **45,** wherein the first material and the second material have a different work function, thus forming a contact diode. The second device layer comprises a second line array of contact diodes wherein neighboring contact diodes are separated from one another by lines of insulating material, exemplified by **54.** Each contact diode in the second line array of contact dioades contains a first material, exemplified by **51,** in electrical contact with a second material, exemplified by **52,** wherein the first material and the second material have a different work function, thus forming a contact diode. **Figure 8** further shows continuous, electric field programmable film layers, **46** and **53,** and line arrays comprising electrode lines, exemplified by **48** and **55,** and insulating lines, exemplified by **49** and **56,** respectively. In some aspects of these embodiments, the material used in insulating layer **50** isolates the various device layers from one another electrically, thermally, optically or some combination thereof. In some aspects of these embodiments, the material used in insulating layer **50** is etchable allowing via holes to be formed therein to facilitate interconnection of the various device layers. In some aspects of these embodiments, the material used in insulating layer **50** is selected from inorganic isolation materials, for example, silicon oxide (formed by chemical vapor deposition from the decomposition of tetraethylorthosilicate (TEOS)), other silicates, silicon nitride, silicon oxynitride and titanium dioxide. In some aspects of these embodiments, the material used in insulating layer **50** is selected from organic and organosilicon isolation materials, for example, spin-on glass formulations comprising siloxanes having C₁-C₁₀ alkane substitution, substituted silsesquioxanes having C₁-C₂₀ alkyl, aryl and/or alkylaryl substitution, fluoropolymers comprising tetrafluoroethylene and polyimides.

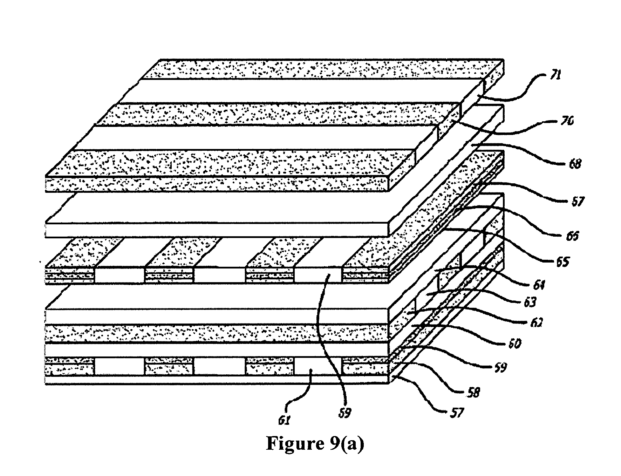

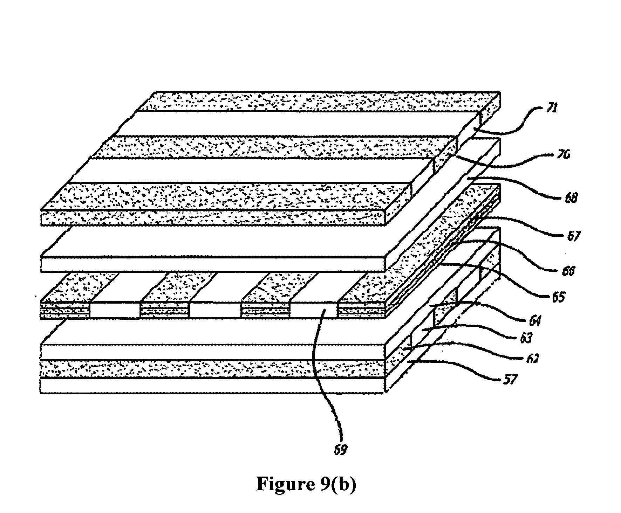

In some embodiments of the present invention, at least one pair of device layers share an electrode. For example, in **Figure 9(a),** there is depicted a cutaway, partially exploded view of a three layer, stacked, cross-point array data storage device of the present invention in which device layers share an electrode. **Figure 9(a)** depicts a stacked data storage device having a substrate **57** and three device layers. The first device layer comprises a first line array of first contact diodes wherein neighboring first contact diodes are separated from one another by lines of insulating material, exemplified by **61.** Each first contact diode contains a first material, exemplified by **58,** in electrical contact with a second material, exemplified by **59,** wherein the first material and the second material have a different work function. The first device layer further comprises a first, continuous layer of electric field programmable film **60** in electrical contact with (i) the first line array of contact diodes and (ii) a first line array of electrodes, exemplified by **62,** and insulators, exemplified by **63.** The second device layer shares the first line array of electrodes with the first device layer and further contains a second continuous layer of electric field programmable film, **64;** and a second line array of second contact diodes separated from one another by lines of insulating material, exemplified by **69;** wherein the second continuous layer of the electric field programmable film is in electrical contact with the first line array of electrodes and the second line array of second contact diodes. Each second contact diode contains a first material, exemplified by **66,** in electrical contact with (i) a second material, exemplified by **65,** and (ii) a third material, exemplified by **67;** wherein the second material and the third material have a different work function from that of the first material. The third device layer shares the the second line array of second contact doides with the second device layer and further contains a third continuous layer of electric field programmable film **68** and a second line array of electrodes, exemplified by **70,** and insulators, exemplified by **71.** In some aspects of these embodiments, the first and second contact diodes comprise (i) a metal having a work function between 2.7 and 4.9 eV and (ii) a conducting polymer having a work function greater than 4.5 eV. In some aspects of these embodiments, the first and second contact diodes comprise a material selected from p-doped silicon, n-doped silicon, p-doped amorphous silicon, n-doped amorphous silicon, p-doped polycrystalline silicon, n-doped polycrystalline silicon, tantalum suicide, titanium silicide, tungsten silicide, vanadium silicide, polyacetylene, polypyrrole, polyaniline, polythiophene, poly(3,4-ethylenedioxythophene), PEDOT-PSS, poly(para-phenylene), poly(pyridine), polyfuran, polyfluorene, polyphenylenevinylene, polyselenophene, poly(perinaphthalene), polyazulene, polycarbazole, polyindole, polypyrene, poly(p-phenylene sulfide), polyphenylene oxide, polyquinoline, polyacenaphthylenediyl, polyisothianaphthene, polynaphthothiophene, poly(p-hydro-quinone-alt-thio- phene) or poly(furan-co-phenylene).

In some embodiments of the present invention, at least one pair of device layers share an electrode. For example, **Figure 9(b)** a cutaway, partially exploded view of another stacked cross-point array data storage device of the present invention having two device layers on a substrate, which layers share an electrode. **Figure 9(b)** depicts a stacked data storage device having a substrate, **57,** and two device layers. The first device layer comprises a first line array of electrodes, exemplified by **62,** and insulators, exemplified by **63.** The first device layer further contains a first continuous layer of electric field programmable film **64;** and a first line array of contact diodes; wherein the first continuous layer of the electric field programmable film is in electrical contact with the first line array of electrodes and the second line array of contact diodes. Each contact diode comprises a first material, exemplified by **66,** in electrical contact with (i) a second material, exemplified by **65,** and (ii) a third material, exemplified by **67;** wherein the second material and the third material have a different work function from that of the first material; thus forming a contact diode. The second device layer shares the first line array of contact diodes with the first device layer and further contains a second continuous layer of electric field programmable film **68** and a second line array of electrodes, exemplified by **70,** and insulators, exemplified by **71.**

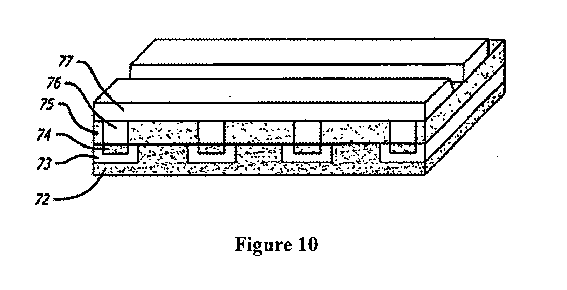

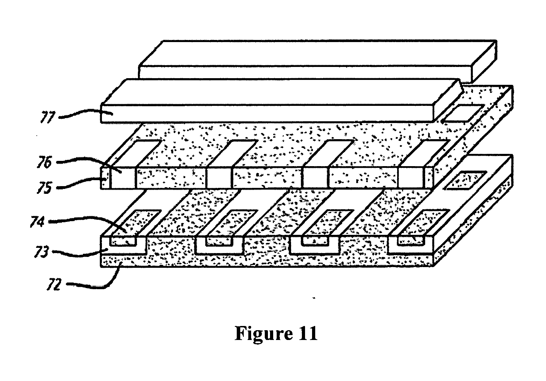

**Figure 10** depicts a cutaway view of a cross-point array memory device of the present invention with memory cells isolated by junction diodes. **Figure 11** depicts a cutaway, exploded view of the memory device depicted in **Figure 10.** The devices depicted in **Figures 10** and **11** comprise a p- type semiconductor substrate **72,** an array of n+ bit lines, exemplified by **73,** a plurality of p+ zones doped within each bit line, exemplified by **74,** a plurality of individual electric field programmable film elements, exemplified by **76,** with a patterned matrix for isolating the individual electric field programmable film elements **75,** and an array of word lines, exemplified by **77;** wherein each word line is in electrical contact with a row of individual electric field programmable film elements. The p+ zones **74** and the n+ bit lines **73** form an array of isolation diodes, which electrically isolate the intended memory cells for reading, writing, erasing and addressing from the other memory cells in the device.

While the devices depicted in the **Figures** show only a few device layers for simplicity, a larger number is contemplated in accordance with the appended claims.

In some embodiments of the present invention, the electric field programmable film may be used as a medium for mass data storage. In one aspect of this embodiment, the field programmable film may have a thickness of 5 to 500 nm; alternatively 10 to 200 nm; alternatively 10 to 100 nm. In some aspects of this embodiment, the film may be disposed on a conducting or semiconducting substrate.

In a memory or data storage mode, programming and reading of individual memory cells can be accomplished by applying to a select memory cell a voltage in a given range to program the select memory cell in a given data state, applying to the select memory cell a sub-program voltage to read the cell to determine what data state it is in.

In some embodiments of the present invention, data storage is achieved by applying a voltage pulse sequence at appropriate levels to read and program the memory cell as desired. In some aspects of these embodiments, the applied voltage may be approximately -12V to 12V to program and 0.2V to 10V to read. Alternatively, the applied voltage may be approximately -5V to 5V to program and 0.2V to 4V to read. One skilled in the art will immediately recognize that the voltage applied for the read must be less than the minimum program voltage to avoid a "read disturb", or unintentional re-write of the cell. The term "minimum program voltage" used herein and in the appended claims refers to the minimum voltage required to change a memory cell from one data state to another data state for a given device configuration. The duration of the pulses may be 0.5 to 10,000 nanoseconds, alternatively 2 to 100 nanoseconds, alternatively 1 to 50 nanoseconds.

In some embodiments of the present invention, the methods of the present invention further comprise reading data programmed to the cross-point memory array. In some aspects of these embodiments, reading the data comprises determining the data state of at least one of the at least one memory cell by determining the conductivity of the electric field programmable film in the at least one of the at least one memory cell.

In some embodiments of the present invention, the electric field programmable film includes a first data state, a second data state and a third data state; wherein the first data state corresponds to a first impedance state of the electric field programmable film; wherein the second data state corresponds to a second impedance state of the electric field programmable film and wherein the third data state corresponds to a third impedance state of the electric field programmable film.

In some embodiments of the present invention, the method for storing multi-bit data in a memory device comprising a cross-point memory array, comprises: providing a bit line array; providing a word line array; selecting an electric field programmable film composition from formulation A and formulation B; obtaining an electric field programmable film with the electric field programmable film composition; providing at least one memory cell comprising the electric field programmable film (i) disposed within a spatial intersection between at least one bit line in the bit line array and at least one word line in the word line array and (ii) electrically coupled with the at least one bit line and the at least one word line; and writing data to the cross-point memory array by applying a program voltage across the electric field programmable film in at least one of the at least one memory cell to program the at least one of the at least one memory cell to one of at least three different data states; wherein formulation A comprises a binder, at least one electron donor and at least one electron acceptor; wherein at least one of (i) the at least one electron donor and (ii) the at least one electron acceptor is chemically bound to the binder; and wherein either (i) the at least one electron donor comprises at least two electron donors having different ionization potentials; or (ii) the at least one electron acceptor comprises at least two electron acceptors having different electron affinities; and, wherein formulation B comprises a binder, at least one electron donor and at least one electron acceptor; wherein formulation B either (i) contains less than 0.05 wt% of electron donor(s) or (ii) contains less than 0.05 wt% of electron acceptor(s); and wherein either (i) the at least one electron donor comprises at least two electron donors having different ionization potentials; or (ii) the at least one electron acceptor comprises at least two electron acceptors having different electron affinities. In some aspects of these embodiments, formulation A further comprises a donor-acceptor complex; and, formulation B further comprises a donor-acceptor complex. In some aspects of these embodiments, at least one electron donor comprises at least two electron donors. In some aspects of these embodiments, the at least one electron acceptor comprises at least two electron acceptors.

In some embodiments of the present invention, the memory device comprises at least two cross-point memory arrays.

Some embodiments of the present invention will now be described in detail in the following Examples. Note that all of the chemicals used in the examples are available from Aldrich Chemical, Milwaukee, WI.

### Example 1

### Synthesis of gold nanoparticles

Gold nanoparticles were synthesized at room temperature using a method detailed by M. J. Hostetler, et. al., Langmuir, 14 (1998) 17. To an aqueous solution containing 7.0 grams (g) (17.8 millimole (mmol)) of tetrachloroauric acid (HAuCl₄·3H₂O), in 100 milliliters (mL) of water was added a solution of 27.0 g (49.4 mmol) tetraoctylammonium bromide in 500 g of toluene. The mixture was stirred vigorously for 45 minutes. The organic layer was separated, and to the separated organic layer was added 7.2 g (35.6 mmol) dodecanethiol (DSH). The resulting solution was stirred for 15 min at room temperature. A solution of NaBH₄ (6.8 g, 180 mmol) in 100 g of water was then added over a 10 sec period with vigorous stirring and the resulting mixture was further stirred for 3 h at room temperature. The dark colored toluene phase was collected, washed twice with 100 mL of water using a separatory funnel and reduced in volume to approximately 50 mL under vacuum in a rotary evaporator. At this point, 300 mL of ethanol were added, and the sample refrigerated overnight at 3°C. The precipitate was then isolated by decanting, and the supernatant centrifuged to recover suspended matter. These recovered solids were combined with the precipitate, washed with acetone, and redissolved in 40 mL toluene. To this solution another 300 mL of ethanol was added, and the refrigeration, decanting, and centrifugation repeated. The resulting solids were again washed in acetone and dried to yield 4.58 g of gold nanoparticles having a bimodal particle size distribution.

### Example 2

### Synthesis of 9-Anthracenemethyl Methacrylate/2-Hydroxyethy Methacrylate/3-(Trimethoxysilyl)propyl Methacrylate Terpolymer (54/17/29 mol/mol/mol)

This reaction was performed at several scales. In a typical synthesis, a 500 mL round bottomed sidearm flask (the "reactant reservoir") was charged with propylene glycol methyl ether acetate (PGMEA) (117.5 g), 9-anthracenemethyl methacrylate (46.0 g, 166 mmol), 2-hydroxyethyl methacrylate (6.82 g, 52.4 mmol), 3-(trimethoxysilyl)propyl methacrylate (22.2 g, 89.4 mmol) and t-amyl peroxy pivalate (7.5 g, 39.8 mmol). The flask was fitted with a rubber septum cap. An outlet tube, connected to an electronically controlled pump was inserted through the septum cap. A 1L 3-neck flask with bottom valve (the "reaction vessel") was equipped with a heating mantle, variable autotransformer, Friedrichs condenser, mechanical stirrer, Claisen head, thermal probe (thermocouple connected to an I2R controller) and N₂ inlet. The flask was charged with PGMEA (about 325 g) and the temperature was then raised to 85°C and allowed to equilibrate. The above described monomer-initiator solution was fed from the reactant reservoir into the reaction vessel at a reactant feed rate of about 1.69 mL/min using an electronically controlled pump (SciLog), previously calibrated for flow rate with PGMEA, such that a total reactant feed time of about 120 min was achieved. Upon completion of the feed, the reaction was stirred at temperature for 30 minutes, at which time a degassed chase of t-amyl peroxy pivalate (7.5 g, 27.5 mmol) and PGMEA (25 g) was fed into the reaction at a rate of about 1.14 mL/min such that a chase feed time of about 30 minutes was achieved. After the initiator chase was complete, the reaction was stirred at temperature for an additional hour, then cooled to room temperature and transferred to a suitable container. Solution concentration was about 13.7%.

### Example 3

### Preparation of an electric field programmable film composition

An electric field programmable film composition was prepared by combining the polymer from Example 2 (13.67% w/w solution in PGMEA, 1.74 g solution, 0.24 g polymer) with the gold nanoparticles from Example 1 (0.06 g) and a 50/50 w/w blend of methoxybenzene and 2-heptanone (12.93 g) to form an electric field programmable film composition. The composition was agitated overnight on a laboratory roller to dissolve the components, sonicated in an ultrasonic bath for 10 min and filtered through a 0.2 micron membrane filter.

### Example 4

### Fabrication and testing of a memory cell

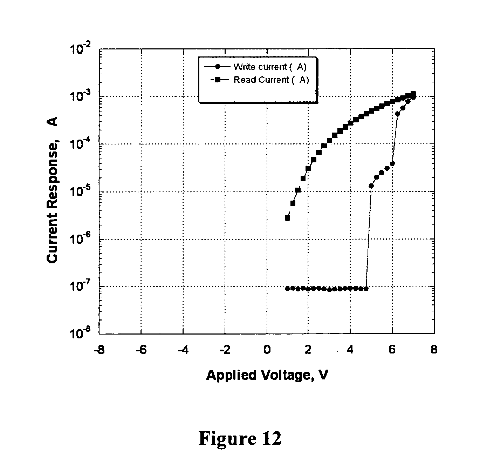

A memory cell was fabricated by spin coating the composition from **Example 3** on a **4** in. silicon wafer (p-type, 0.0001 ― 0.1 Ω-cm) and baking on a hotplate at 110°C for 60 sec and then 200°C for 60 sec to give an electric field programmable film having a thickness of about 50 nm. Aluminum dots of about 0.5 mm in diameter and about 45 nm of thickness were then evaporated thermally on top of the electric field programmable film through a shadow mask at a pressure of about 10⁻⁶ to 5 X 10⁻⁵ torr. Current-voltage characteristics were measured using a Keithley 6517A electrometer with the silicon wafer configured as ground and the aluminum dots configured as the working electrode. The entire measurement was under the control of LabView software (National Instruments Corp.), programmed initially to sweep from 0.0 V to about 7.0 V, from a 7.0 V to 0.0 V and from 0.0 to -7.0 V. The resulting current-voltage curve is provided in **Figure 12**.

## Claims

1. A method for storing multi-bit data in a memory device comprising a cross-point memory array, comprising:
providing a bit line array;
providing a word line array;
providing at least one memory cell comprising an electric field programmable film (i) disposed within a spatial intersection between at least one bit line in the bit line array and at least one word line in the word line array and (ii) electrically coupled with the at least one bit line and the at least one word line; and,
writing data to the cross-point memory array by applying a program voltage across the electric field programmable film in at least one of the at least one memory cell to program the at least one of the at least one memory cell to one of at least three different data states.

2. A method for storing multi-bit data in a memory device comprising a cross-point memory array, comprising:
providing a bit line array;
providing a word line array;
selecting an electric field programmable film composition from formulation A and formulation B;
obtaining an electric field programmable film with the electric field programmable film composition;
providing at least one memory cell comprising the electric field programmable film (i) disposed within a spatial intersection between at least one bit line in the bit line array and at least one word line in the word line array and (ii) electrically coupled with the at least one bit line and the at least one word line; and,
writing data to the at least one memory cell by applying a program voltage across the electric field programmable film in the memory cell to program the memory cell to one of at least three different data states;
wherein formulation A comprises a binder, at least one electron donor and at least one electron acceptor; wherein at least one of (i) the at least one electron donor and (ii) the at least one electron acceptor is chemically bound to the binder; and
wherein either (i) the at least one electron donor comprises at least two electron donors having different ionization potentials; or (ii) the at least one electron acceptor comprises at least two electron acceptors having different electron affinities; and,
wherein formulation B comprises a binder, at least one electron donor and at least one electron acceptor; wherein formulation B either (i) contains less than 0.05 wt% of electron donor(s) or (ii) contains less than 0.05 wt% of electron acceptor(s); and wherein either (i) the at least one electron donor comprises at least two electron donors having different ionization potentials; or (ii) the at least one electron acceptor comprises at least two electron acceptors having different electron affinities.

3. The method of claim 1, further comprising reading data written to the cross-point memory array.

4. The method of claim 3, wherein reading data comprises determining the data state of at least one of the at least one memory cell by determining the conductivity of the electric field programmable film in the at least one of the at least one memory cell.

5. The method of claim 1, wherein the electric field programmable film includes a first data state, a second data state and a third data state; wherein the first data state corresponds to a first impedance state of the electric field programmable film; wherein the second data state corresponds to a second impedance state of the electric field programmable film and wherein the third data state corresponds to a third impedance state of the electric field programmable film.

6. The method of claim 2,
wherein formulation A further comprises a donor-acceptor complex; and,
wherein formulation B further comprises a donor-acceptor complex.

7. The method of claim 1, wherein the memory device comprises at least two cross-point memory arrays.

8. A cross-point memory array device, comprising
a bit line array;
a word line array; and,
a multiplicity of memory cells comprising an electric field programmable film (i) disposed within a spatial intersection between at least one bit line in the bit line array and at least one word line in the word line array and (ii) in electrical coupling with the at least one bit line and the at least one word line;
wherein the cross-point memory array device contains data stored in multi-bit format.

9. A data processing device comprising the cross-point memory array device of claim 8.
